# EUROPEAN PATENT SPECIFICATION

(11) **EP 1 113 500 B1**
(45) Date of publication and mention of the grant of the patent: **07.05.2008**
(21) Application number: 99830828.2
(22) Date of filing: 31.12.1999
(51) Int. Cl.: H01L 29/423, H01L 29/788, H01L 27/115, H01L 21/8247

(54) **Process for manufacturing non-volatile memory cells**
Verfahren zum Herstellen nichtflüchtiger Speicherzellen
Procédé de fabrication de cellules de mémoire non-volatile

(43) Date of publication of application: 04.07.2001
(73) Proprietor: STMicroelectronics S.r.l., 20041 Agrate Brianza (Milano) (IT)
(72) Inventor: Nastasi, Nicola, 98057 Milazzo (ME) (IT); Arcidiacono, Dorotea, 95030 Pedara (CT) (IT); Mazzali, Stefano, 20040 Carnate (MI) (IT)
(74) Representative: Botti, Mario

(56) References cited:
- US-A- 5 493 140
- US-A- 5 973 353
- PATENT ABSTRACTS OF JAPAN vol. 1995, no. 11, 26 December 1995 (1995-12-26) & JP 07 202047 A (FUJITSU LTD;OTHERS: 01), 4 August 1995 (1995-08-04)
- PATENT ABSTRACTS OF JAPAN vol. 1998, no. 10, 31 August 1998 (1998-08-31) & JP 10 125812 A (TOSHIBA CORP), 15 May 1998 (1998-05-15)

## Description

### Field of the Invention

This invention relates to a process for manufacturing non-volatile memory cells, integrated on a semiconductor substrate, in particular in Flash EEPROM cells.

Specifically, the invention relates to a process for manufacturing electronic non-volatile memory devices which are integrated on a semiconductor substrate and constructed with a matrix of memory cells having floating gate regions formed in respective active areas.

The invention particularly, but not exclusively, relates to an improved method of planarizing matrices of non-volatile, specifically Flash EEPROM, memory cells, and the description which follows will make reference to this application field for only convenience of explanation.

### Prior Art

As is well known, semiconductor-integrated electronic Flash EEPROM memory devices comprise a plurality of non-volatile memory cells which are organized in matrix form, that is to say, that the cells are organised into rows or word lines and columns or bit lines.

Each non-volatile memory cell comprises a MOS transistor provided with a floating gate above its channel region, i.e. an electrode having a high direct impedance to all the other terminals of the same cell and of the circuit wherein the cell is connected.

The cell also comprises a second electrode, the control gate, which is driven by appropriate control voltages. Other electrodes of the transistor are the usual drain and source electrodes.

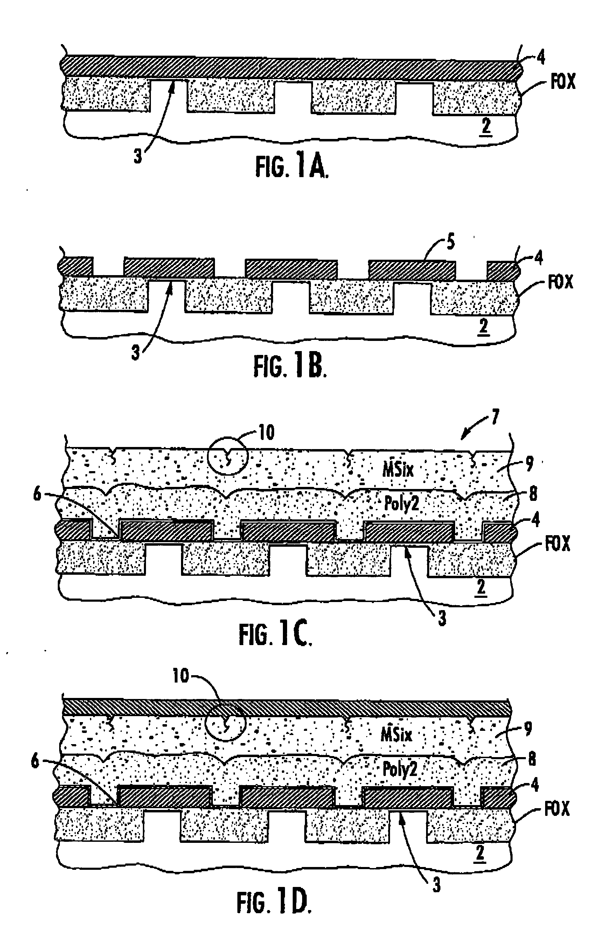

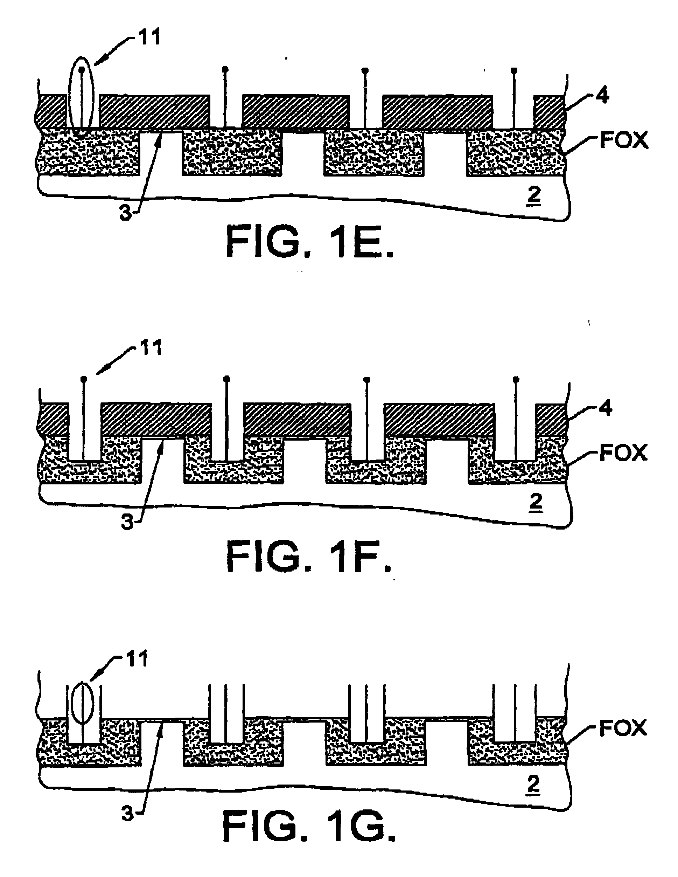

A known process flow for manufacturing Flash EEPROM memory cells 1 integrated in a semiconductor substrate 2 is illustrated in Figures 1A-1E. In such figures are shown vertical cross-sections taken along a parallel direction to the word lines but shifted therefrom to highlight the standard process steps in those areas.

This prior process provides with the formation in the substrate a plurality of active areas, wherein the memory cells later to be formed will be separated from one another by portions of a field oxide layer FOX. On the substrate 2, a first dielectric layer 3, known as the tunnel oxide, and a layer 4 of polycrystalline silicon, are then formed

Thereafter, the process goes through the patterning of the layer 4 to realise a plurality of polycrystalline silicon strips 5, known as the floating gates, which are parallel to one another. Such strips 5 are' separated and isolated from the substrate 2 by means of the oxide layer 3, as shown in Figure 1B.

Following deposition of an interpoly dielectric layer 6, the standard process flow goes through the definition of the word lines 7 by forming a layer 8 of polycrystalline silicon (known as Poly2) and a layer 9 of a metallic silicide MSiₓ, where the metal may be W, tungsten, cobalt.

This metallic silicide layer 9 is cascaded onto, or formed in situ by a silicidation process, on the previously defined Poly2 layer.

The word lines 7 are then defined by a photolithographic process using a mask of a resist, such that such word lines 7 will lie perpendicularly to the floating gate strips 5.

The word lines 7 and floating gate strips 5 usually are defined using a "self-aligned cell" technique, comprising a series of plasma etching operations which may be carried out sequentially in a single fixture, or in several operations optionally separated by suitable cleaning steps between an etch step and another.

In the latter case, the etching of the word lines 7 comprising silicide/Poly2 reaches the interpoly oxide layer 6.

While being an advantageous one for many aspects, this prior process has drawbacks. This memory cell patterning scheme is actually liable to faultiness due the cell morphology. In fact, the spacing of the floating gate strips 5 causes corrugations to appear in the Poly2 layer 8 deposited over the floating gate strips 5, with hollows of increasing depth as the dimensions of the device are scaled, as shown in Figure 1C.

This involves the development of possible cracks 10 in the metallic silicide layer 9 of the word lines. Such cracks 10 are more likely to appear after the cell is sealed by thermal oxidation, upon completion of its patterning, and especially in devices having a layer of WSiₓ deposited over the Poly2 layer.

In the latter devices, the deposition of a second layer 9 intensifies this creasing effect and, with it, the strain on the deposited silicide film.

Faultiness of this kind gives rise to two major disadvantages:
- a high resistance of the word lines 7, with following negative affecting on the electrical performances of the device;
- where an organic reflection-preventer is used in patterning the matrix, an increased rate of rejects or increased redundancy consumption due to shorts occurring between rows and/or cells.

The reflection preventer would penetrate cracks 10, and if its etching is dedicated and uncontextual to the silicide layer 9, removal of the layers of Poly2 8 and silicide 9 would cause the formation of residues 11 as shown in Figure 1E.

Another critical aspect of patterning matrices which comprise flash memory cells is the etching used for the removal of the interpoly dielectric layer 6 to define the source and drain lines in the substrate, as shown in Figure 1F.

This operation causes the loss of a certain thickness of the exposed insulating dielectric at the end of the MSiₓ/Poly2 etching.

A reduced thickness of the field oxide can cause the possible failure of the channel insulation upon implantation (formation of shifts).

The Patent US. 5,973,353 of the Advanced Micro Device Inc. disclosed a method to reduce the severity of the topology attributable to the space between adjacent floating gates, in non-volatile memory device, by tapering the sidewalls of the floating gates.

The Patent US. 5,493,140 of the Sharp Kabushiki Kaisha describes a non-volatile memory cell surrounded by a field oxide layer, that is provided with a recess formed in the field oxide layer:

The underlying technical problem of this invention is to provide with a process for manufacturing non-volatile memory cells with structural features able to reduce cracking at the word lines and preserve the insulation during the cell patterning, such that the drawbacks which still beset prior art devices can be overcome.

### Summary of the Invention

The concept behind this invention is one of patterning the floating gate regions with slanted sidewalls to the surface of the floating gate region, along a parallel direction to the word lines

Based on this concept, the technical problem is solved by a process as previously indicated and defined in Claim 1.

The features and advantages of a device according to the invention can be appreciated from the following description of an embodiment thereof, given by way of example and not of limitation with reference to the accompanying drawings.

### Brief Description of the Drawings

In the drawings:
- Figures 1A to 1G are vertical cross-section views, drawn to an enlarged scale, of a portion of a semiconductor substrate in the course of one embodiment of the prior art fabrication process;
- Figures 2A to 2G are vertical cross-section views, drawn to an enlarged scale, of a portion of a semiconductor substrate in the course of one embodiment of the fabrication process according to the invention;
- Figure 3 is a sectional view of a gate region according to the invention.

### Detailed Description

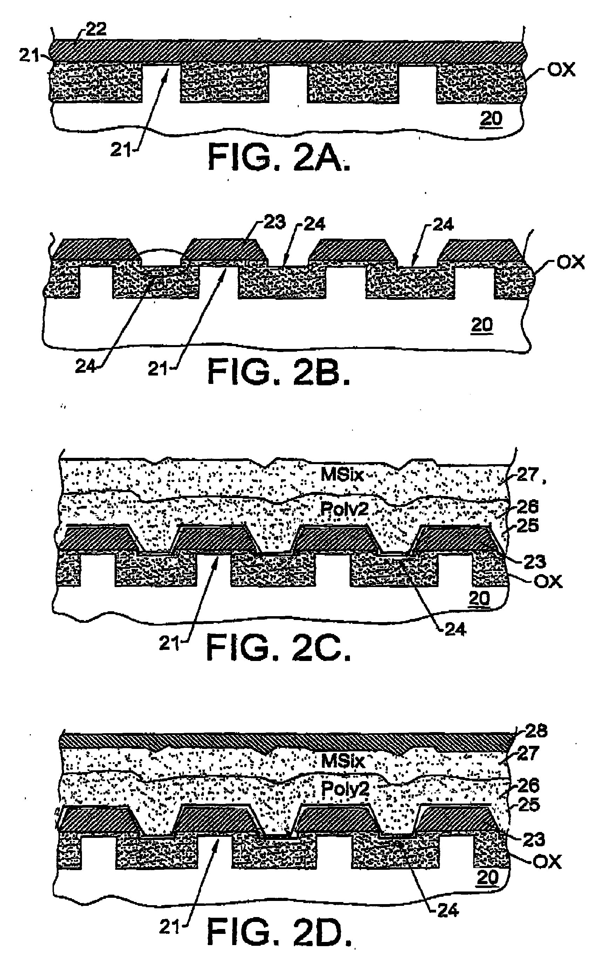

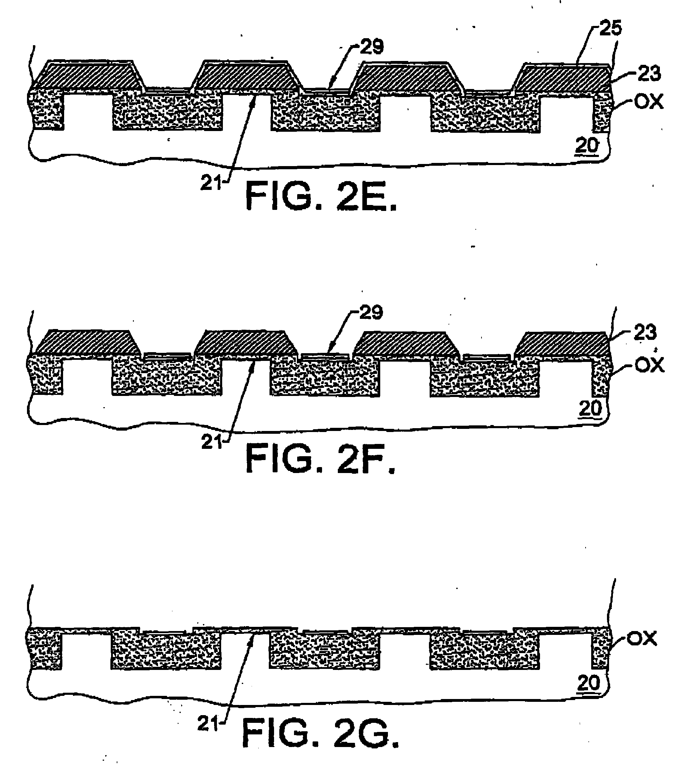

An improved process for planarizing non-volatile memory cells integrated in a semiconductor substrate will now be described with reference to Figures 2A to 2E.

A plurality of active areas are formed on a semiconductor substrate 20 which will be realised to accommodate the memory cells, separated from one another by portions of a layer of field oxide OX. On the substrate 20 a first dielectric layer 21, known as the tunnel oxide layer, and a layer 22 of polycrystalline silicon are then formed.

According to the invention, the process continues with the patterning of the layer 22 to produce a plurality of parallel polycrystalline silicon strips 23, known as floating gates. This patterning step is carried out to produce the floating gate by a different principle.

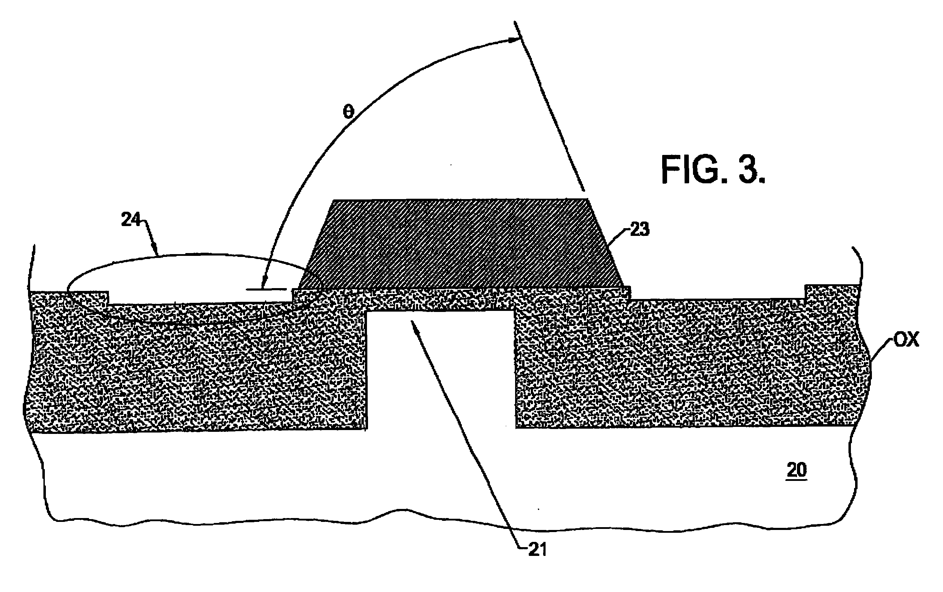

Instead of patterning the floating gate with vertical walls along the perpendicular direction to the direction of the strips 23, through a plasma etching down to the field oxide while maintaining a high Poly/oxide selectivity, the strips 23 are defined with slanted walls (θ<85, where θ is the base angle of the Poly1 layer), e.g. by end-point etching as shown in Figure 3.

A trench (a "bed") 24 is dug by an appropriate overetching operation in the field oxide which is exposed during the step of definition of the floating gate strips 23.

The "bed" 24 dug in the field oxide layer should be of minimal depth: h = h_{ONO} + h', where h is the depth of the bed 24 dug in the field oxide, h_{ONO} is the thickness of the interpoly dielectric to be deposited at a later stage (usually of the ONO variety), and h' is the least thickness of polycrystalline silicon necessary to protect the field oxide layer from the interpoly oxide etching during the matrix patterning.

The value of h' is selected according to the oxide/silicon selectivity of the etch employed, and its duration.

The process continues through the steps of depositing an interpoly dielectric layer 25, of forming a polycrystalline silicon layer (known as Poly2) 26, and optionally of depositing a layer 27 of an MSiₓ metallic silicide wherein the metal may be W, tungsten, cobalt.

This layer 27 of metallic silicide may be cascade deposited, or formed in situ by a silicidation step carried out on the Poly2 layer previously defined.

As can be seen in Figures 2C and 2D, the sloping walls of the floating gate provide with a lead-in for filling the gaps between the floating gate strips so that a smoother profile for the Poly2 is obtained, thereby reducing the strain on the silicide layer and, ultimately, the device faultiness from technological limitations.

Word lines are then defined by a photolithographic process using a mask of a resist, such that the word lines will extend perpendicularly to the floating gate strips 23. Figures 2E-2F show a section of the memory matrix, taken parallel to the word lines, but in which the excess Poly2 and silicide layers, used for defining the word lines, have been removed.

The final definition of the cells is completed by using the self-aligned cell technique.

It should be underlined, that the patterning of Poly1 with sloping walls is only carried out along the direction of the floating gate strips. In fact, in defining the cell at the level of the self-aligned Poly1, the walls of the floating gate which happens to coincide with the walls of the word line are vertically defined. This avoids, therefore, a physical reduction in length of the oxide spacers necessary to produce a gradual cell junction.

The provision of the trench 24 is effective to overcome another critical aspect of defining flash memories, namely the reliability of the insulation or field in the matrix.

In fact, the presence of the trench 24 to a greater depth than the thickness of the interpoly layer 25 allows to realise a plug 29 formed by the Poly2 layer 26.

The presence of this plug 29 (a spacer) of Poly2 located below the level of the floating gate, for a minimal loss of the field oxide layer thickness, prevents this oxide from being etched away during the interpoly dielectric etching step without, however, creating shorting bridges of Poly1 between the cells.

To summarize, the process of this invention allows, in the first place, to reduce the inherent faultiness of the layer of polycrystalline silicon/metallic silicide, as well as in the consequent faultiness during the definition of the matrices of Flash EEPROM devices, thanks to a morphology that effectively relieves layer straining, and advantageously allows insulation between the matrix cells to retain its integrity.

Both advantages are achieved by making minimal variations to the definition of the floating gate strips, and keeping the definition scheme for the device matrix unaltered.

Furthermore, improved capacitive coupling of the floating gates is to be expected because of the slanted sidewalls, which place them closer together.

## Claims

1. A process for manufacturing electronic non-volatile memory devices which are integrated in a semiconductor substrate and constructed with a matrix of memory cells having floating gate regions formed on respective active areas, comprising the following steps in the sequence given:
- forming sidewalls of said floating gate regions that are slanted with respect to the surface of the semiconductor substrate so that a lead-in for upper layers is formed,
- digging a trench (24) in a thick oxide layer delimiting the active areas of the cells,
- depositing an interpoly dielectric layer (25),
- forming a plug (29) of polycrystalline silicon in order to partially fill said trench (24),
- etching the interpoly dielectric layer (25)
the presence of the plug (29) preventing the thick oxide layer from, being etched away during the interpoly dielectric layer etching step.

2. A process according to Claim 1, **characterized in that** said floating gate regions are formed by means of an end-point etching step.

3. A process according to Claim 2, **characterized in that** the walls of the floating gate regions are set at an inclination angle θ of less than 85° to the substrate surface.

4. A process according to Claim 1, **characterized in that** said trench is produced by overetching through the thick oxide layer.

## Patentansprüche

1. Verfahren zum Herstellen elektronischer nichtflüchtiger Speichervorrichtungen, die in ein Halbleitersubstrat integriert sind und mit einer Matrix aus Speicherzellen mit auf entsprechenden aktiven Flächen gebildeten Floating-Gate-Bereinhen konstruiert sind, aufweisen folgendende Schritte in der gegebenen Abfolge:
- Bilden von Seitenwänden der Floating-Gate-Bereiche, die bezüglich der Oberfläche des Halbleitersubstrats abgeschrägt sind, so dass eine Einführung für obere Schichten gebildet wird,
- Graben einer Ausnehmung (24) in einer dicken Oxidschicht, die die aktiven Flächen der Zellen begrenzt,
- Niederschlagen einer dielektrischen Interpolysilizium-Schicht (25),
- Bilden eines Stopfens (29) aus Polykristallinsilizium, um die Ausnehmung (24) teilweise zu füllen.
- Ätzen der dielektrischen Interpolysilizium-Schicht (25),
wobei die Gegenwart des Stopfens (29) verhindert, dass die dicke Oxidschicht während des Schritts des Ätzens der dielektrischen Interpolysilizium-Schicht weggeätzt wird.

2. Verfahren nach Anspruch 1, **dadurch gekennzeichnet, dass** die Floating-Gate-Bereiche mittels eines Endpunktätzschritts gebildet werden.

3. Verfahren nach Anspruch 2, **dadurch gekennzeichnet, dass** die Wände der Floating-Gate-Bereiche in einem Neigungswinkel θ von weniger als 85° zu der Substratoberfläche eingerichtet werden.

4. Verfahren nach Anspruch 1, **dadurch gekennzeichnet, dass** die Ausnehmung durch Überätzen durch die dicke Oxidschicht hergestellt wird.

## Revendications

1. Procédé pour fabriquer des dispositifs électroniques de mémoires rémanentes qui sont intégrés dans un substrat semi-conducteur et sont constitués par une matrice de cellules de mémoire ayant des régions de grilles flottantes formées sur des zones actives respectives, comprenant les étapes suivantes, dans l'ordre indiqué, consistant à :
- former des parois latérales desdites régions de grilles flottantes qui sont obliques par rapport à la surface du substrat semi-conducteur de façon que soit formée une zone d'entrée pour des couches supérieures,
- creuser dans une épaisse couche d'oxyde une tranchée (24) délimitant les zones actives des cellules,
- déposer une couche de diélectrique interpoly (25),
- former un bouchon (29) de silicium polycristallin afin de remplir partiellement ladite tranchée (24),
- attaquer chimiquement la couche de diélectrique interpoly (25),
la présence du bouchon (29) empêchant que l'épaisse couche d'oxyde ne soit emportée par attaque chimique pendant l'étape d'attaque chimique de la couche de diélectrique interpoly.

2. Procédé selon la revendication 1, **caractérisé en ce que** lesdites régions de grilles flottantes sont formées à l'aide d'une étape d'attaque chimique de points d'extrémités.

3. Procédé selon la revendication 2, **caractérisé en ce que** les parois des régions de grilles flottantes sont inclinées suivant un angle θ inférieur à 85° par rapport à la surface du substrat.

4. Procédé selon la revendication 1, **caractérisé en ce que** ladite tranchée est réalisée par attaque chimique débordante à travers l'épaisse couche d'oxyde.
